# EUROPÄISCHE PATENTSCHRIFT

(11) **EP 3 700 855 B1**
(45) Veröffentlichungstag und Bekanntmachung des Hinweises auf die Patenterteilung: **02.12.2026**
(21) Anmeldenummer: 18783466.8
(22) Anmeldetag: 08.10.2018
(51) Int. Cl.: B81C 1/00

(54) **MIKROELEKTROMECHANISCHES BAUTEIL SOWIE EIN VERFAHREN ZU SEINER HERSTELLUNG**
MICROELECTROMECHANICAL COMPONENT AND METHOD FOR PRODUCING SAME
COMPOSANT MICRO-ÉLECTROMÉCANIQUE ET SON PROCÉDÉ DE FABRICATION

(30) Priorität: 23.10.2017 DE 102017218883
(43) Veröffentlichungstag der Anmeldung: 02.09.2020
(73) Patentinhaber: Fraunhofer-Gesellschaft zur Förderung der angewandten Forschung e.V., 80686 München (DE)
(72) Erfinder: RUDLOFF, Dirk, 01309 Dresden (DE); FRIEDRICHS, Martin, 01307 Dresden (DE); DÖRING, Sebastian, 01109 Dresden (DE); HÜRRICH, Arnd, 01445 Radebeul (DE)
(74) Vertreter: Pfenning, Meinig & Partner mbB
(86) Internationale Anmeldenummer: PCT/EP2018/077310
(87) Internationale Veröffentlichungsnummer: WO 2019/081192

(56) Entgegenhaltungen:
- KR-B1- 100 758 641
- US-A1- 2010 289 065
- US-A1- 2012 261 830

## Beschreibung

Die Erfindung betrifft mikroelektromechanische Bauteile sowie ein Verfahren zu seiner Herstellung.

Angewandt werden soll die Erfindung bei mikroelektromechanischen Bauteilen (MEMS-Bauteilen), die auf CMOS-Schaltkreisen angeordnet sind. Die Herstellung von MEMS-Bauteilen bedient sich verschiedener mikromechanischer Herstellungsmethoden, unter anderem der Verwendung von Opferschichten. Diese werden häufig aus Siliziumdioxid hergestellt. Um die spätere Beweglichkeit des MEMS-Bauteils zu gewährleisten, muss die Opferschicht bereichsweise entfernt werden (Releaseprozess). Im Falle von Siliziumdioxid kann dies mittels Flusssäure (HF) durch Ätzen erreicht werden, die entweder in flüssiger oder in Gasform eingesetzt wird. Ist das MEMS-Bauteil auf einem CMOS-Schaltkreis angeordnet, so müssen die im CMOS-Schaltkreis ebenfalls vorliegenden Siliziumdioxidschichten vor einem möglichen Angriff durch Flusssäure geschützt werden, um deren Funktionalität als Gateoxid oder Isolator zwischen verschiedenen Metalllagen zu gewährleisten. Insbesondere im CMOS-Teil werden häufig dotierte Siliziumdioxidschichten z.B. aus Borphosporsilikatglas (BPSG) verwendet. Diese zeigen eine deutlich höhere Ätzrate, als das undotierte Silikatglas (USG) in den Opferschichten und sind daher besonders anfällig bei einem Ätzen mit Flusssäure. Kommt es zum Ätzangriff innerhalb des CMOS-Bereichs kann es zu Kurzschlüssen oder zur Delamination von Schichten kommen. Beim Angriff vom äußeren Rand her, kann eine zu weit reichende Delamination dazu führen, dass sich elektrische Kontakte (Bondpads) sowie funktionelle Teile des MEMS-Bauteils vom eingesetzten CMOS-Schaltkreis lösen. Ein Drahtbonden und damit eine Verwendung eines derart betroffenen MEMS-Bauteils sind anschließend nicht mehr möglich. Daher muss der CMOS-Bereich des MEMS-Bauteils wirksam vor einem möglichen Angriff während des Releaseprozesses geschützt werden.

Es existieren eine Reihe von Untersuchungen, um einen Angriff auf der CMOS-Schaltkreisoberseite, auf der der MEMS-Teil eines MEMS-Bauteils aufliegt, zu verhindern. Der seitliche Schutz des CMOS-Schaltkreises wurde bisher weitgehend vernachlässigt und lediglich ein genereller Schutz bzw. ein Schutz von oben, also aus Richtung des aufliegenden MEMS-Teils behandelt. Ein Schutz des CMOS wird z.B. in US 2016/0068388 A1 behandelt. Dort wird eine zusätzliche Metalllage, die eine Oberfläche bedeckt, vorgeschlagen. Dies stellt eine einfache und vermutlich auch oft genutzte Methode dar. Als Materialien wurden Titan, Titannitrid, Aluminium sowie Aluminiumkupfer vorgeschlagen. In US 2016/0068388 A1 wird allerdings auch angemerkt, dass die Materialien keine vollständige Resistenz gegen Flusssäure zeigen, sondern korrodieren und somit nur über eine gewisse Dauer einen wirksamen Schutz gewährleisten können. Daher muss die Dicke hinreichend groß gewählt werden.

So ist aus US 2012/0261830 A1 eine mikroelektromechanische Vorrichtung mit Ätzstop bekannt.

US 2010/0289065 A1 betrifft mikroelektromechanische Elemente mit integriertem Chip und kreuzweiser Verbindung.

KR 100 758 641 B1 beschreibt ein Verfahren zur Herstellung von Mikrostrukturen auf Siliziumdioxid mit einer CMOS-Schaltung und eine mikroelektromechanische Vorrichtung mit einer so hergestellten Mikrostruktur.

Es ist daher Aufgabe der Erfindung, Möglichkeiten für einen verbesserten Schutz eines CMOS-Schaltkreises eines MEMS-Bauteils bei der Freilegung eines mikroelektromechanischen Elements zu dessen freier Bewegbarkeit durch eine Entfernung von Siliziumdioxid als Opferwerkstoff mit einem Ätzprozess (Releaseprozess) anzugeben und insbesondere dabei Delaminationen zu vermeiden.

Erfindungsgemäß wird diese Aufgabe mit einem Bauteil, das die Merkmale des Anspruchs 1 aufweist, gelöst. Anspruch 6 definiert ein Herstellungsverfahren. Vorteilhafte Ausgestaltungen und Weiterbildungen der Erfindung können mit in untergeordneten Ansprüchen bezeichneten Merkmalen realisiert werden.

Bei einem erfindungsgemäßen mikroelektromechanischen Bauteil sind mindestens ein mikroelektromechanisches Element, und elektrische Kontaktierungselemente, auf einer Oberfläche eines CMOS-Schaltkreissubstrates ausgebildet. Das mikroelektromechanische Element ist dabei in mindestens einem Freiheitsgrad frei beweglich angeordnet, wie dies auch aus dem Stand der Technik bekannt ist. Erfindungsgemäß ist am äußeren Rand des mikroelektromechanischen Bauteils, radial um alle Elemente des CMOS-Schaltkreises umlaufend, eine gegenüber Flusssäure resistente, gas- und/oder fluiddichte geschlossene Schicht, die mit Silizium oder Aluminiumoxid gebildet ist, auf der Oberfläche des CMOS-Schaltkreissubstrates ausgebildet.

Diese Schicht bildet einen radial umlaufenden Schutzring und vermeidet einen Angriff des Ätzmittels, insbesondere von Flusssäure auf dafür kritische Bereiche, insbesondere des CMOS-Schaltkreises. Der Schichtwerkstoff sollte gegenüber Flusssäure bei der Entfernung von Opferschichtwerkstoff durch Ätzen zumindest so lange resistent sein, bis der Opferschichtwerkstoff in ausreichendem Maß entfernt worden und eine Bewegbarkeit eines jeweiligen mikroelektromechanischen Elements erreicht ist.

Vorteilhaft sollte die Schicht mit amorphem Silizium (aSi) und bevorzugt mit dotiertem amorphem Silizium gebildet sein. Für die Dotierung kann man insbesondere Bor einsetzen. Alternativ wären jedoch auch Aluminiumoxid, Germanium oder eine chemische Verbindungen aus Silizium und Germanium denkbar.

Bei dem Siliziumdioxid muss es sich nicht um reines Siliziumdioxid handeln. Es können auch Dotierungen oder Zuschlagstoffe im Siliziumdioxid enthalten sein und so z.B. Bor-Phosphor-Silikatglas zum Einsatz kommen.

Vorteilhaft ist es auch, wenn an der Oberfläche des mikroelektromechanischen Bauteils an der das mikroelektromechanische Element beweglich angeordnet ist, eine Sperrschicht aus Aluminiumoxid ausgebildet ist. Diese Sperrschicht kann insbesondere elektrische Kontaktierungselemente, die unterhalb der Sperrschicht in der Opferschicht angeordnet sind, vor einem Ätzangriff schützen.

Vorteilhaft kann eine radial umlaufende Schicht, die mit Silizium oder Aluminiumoxid gebildet ist, eine größere Höhe aufweisen, so dass sie lateral über die Oberfläche des CMOS-Schaltkreissubstrates hinausragt und auch einen seitlichen Schutz gegen einen Angriff des eingesetzten Ätzmittels bieten kann.

Die radial umlaufende Schicht sollte eine Höhe aufweisen, die mindestens der Höhe des CMOS-Schichtaufbaus entspricht. Sie kann auch so ausgebildet sein, dass sie einen Schutzring um den CMOS-Schalkreis herum bilden kann. Sie kann dabei ausgehend von der Oberfläche des CMOS-Schalkreissubstrates bis zu einer Sperrschicht direkt bis an die Unterseite des mikroelektromechanischen Elements ausgebildet sein.

Es besteht auch die Möglichkeit, dass die Schicht, die mit Silizium, Aluminiumoxid, Germanium oder einer chemischen Verbindung von Silizium und Germanium gebildet ist, mit mindestens einer weiteren Schicht überbeschichtet ist. Mindestens eine weitere Schicht kann bevorzugt mit einem Metall, besonders bevorzugt mit Titan, Aluminium, Aluminiumkupferlegierung oder einer Titanaluminiumlegierung oder Titannitrid gebildet sein. Auch diese weitere Schicht kann Teile des CMOS-Schaltkreises und elektrische Kontaktierungselemente, die innerhalb der Opferschicht angeordnet sind, vor einem Ätzangriff, insbesondere ausgehend vom Rand des MEMS-Bauteils schützen. Die mit Silizium oder Aluminiumoxid gebildete Schicht schützt dann überwiegend die Oberfläche des CMOS-Schaltkreissubstrates.

Mikroelektromechanische Elemente, können beispielsweise schwenkbare reflektierende Elemente (Mikrospiegel) oder Membranen sein.

Bei der Herstellung eines erfindungsgemäßen MEMS-Bauteils wird so vorgegangen, dass auf einer Oberfläche des CMOS-Schaltkreissubstrates eine Isolatorschicht, die mit Siliziumdioxid gebildet ist, aufgebracht und in die Isolatorschicht dabei lokal definiert elektrische Kontaktierungselemente oder elektrische Leiterbahnen eingebettet werden, wie dies aus dem Stand der Technik bekannt ist. Erfindungsgemäß wird in der Isolatorschicht am äußeren Rand mindestens ein bis zur der Oberfläche des CMOS-Schaltkreissubstrates reichender Graben radial um alle Elemente des CMOS-Schaltkreises umlaufend ausgebildet. Anschließend wird der Graben zumindest in seinem Bodenbereich mit einer fluid- und/oder gasdichten geschlossenen Schicht, die mit Silizium, oder Aluminiumoxid gebildet ist, ausgefüllt. Die Dichtheit sollte den Aggregatzustand des Ätzmittels, insbesondere der Flusssäure bei deren Einsatz zum Entfernen von Opferschichtwerkstoff berücksichtigen. Des Weiteren muss das Material, aus dem die dichte umlaufende Schicht besteht, selbst resistent gegenüber der eingesetzten Flusssäure sein.

Die dichte geschlossene Schicht kann bevorzugt auch mit amorphem Silizium und besonders bevorzugt einer chemischen Verbindung von Silizium mit Bor oder Germanium gebildet sein.

Darauf wird dann ggf. mit Ausbildung weiterer elektrischer Kontaktierungselemente, elektrischer Leiterbahnen oder Elektroden fortgefahren, sowie eine Opferschicht ausgebildet. Die Opferschicht ist ebenfalls mit Siliziumdioxid gebildet. Der Opferschichtwerkstoff kann mit dem Werkstoff für die Isolatorschicht identisch sein. Beide Werkstoffe können aber auch eine unterschiedliche Konsistenz aufweisen, indem sie anders dotiert sind oder andere Stoffe im Siliziumdioxid zusätzlich enthalten sind. Im Siliziumdioxid mit dem Isolator- und/oder Opferschicht gebildet sind können an sich bekannte Zuschlagstoffe für Gläser, insbesondere Bor und Phosphor enthalten sein.

Auf diesem mit umlaufender Schutzschicht versehenen CMOS-Schaltkreis wird anschließend ein beliebiges MEMS-Element aufgebracht.

Im Anschluss daran wird mit einem Ätzverfahren Opferschichtwerkstoff entfernt, so dass eine Bewegbarkeit des mindestens einen mikroelektromechanischen Elements erreicht wird.

Der Graben kann überwiegend mit Silizium oder Aluminiumoxid, bevorzugt aber vollständig mit Silizium ausgefüllt werden. Dadurch kann der seitliche Schutz vor einem Ätzangriff zusätzlich verbessert werden.

Die Isolatorschicht kann sukzessive in mehreren Verfahrensschritten nach einander ausgebildet werden. Zwischen diesen Verfahrensschritten können in an sich bekannter Weise elektrische Kontaktierungselemente und/oder elektrische Leiterbahnen ausgebildet und im Isolatorschichtwerkstoff eingebettet werden. Elektrische Kontaktierungselemente und Elektroden können in der Opferschicht eingebettet und durch das Ätzen wieder frei gelegt werden.

Alternativ oder zusätzlich dazu kann die Schicht mit mindestens einer weiteren Schicht, die bevorzugt mit einem Metall, besonders bevorzugt mit Titan, Titannitrid, Aluminium, einer Aluminiumkupferlegierung oder einer Titanaluminiumlegierung gebildet ist, im Graben überdeckt werden.

Zwischen der Isolator- und der Opferschicht kann auch eine geschlossene Sperrschicht aus Aluminiumoxid oder Silizium, insbesondere aSi und auf der in Richtung des mindestens einen mikroelektromechanischen Elements weisenden Oberfläche der Sperrschicht weitere elektrische Kontaktierungselemente, und Elektroden, die für die Betätigung des mikroelektromechanischen Elements erforderlich sind, ausgebildet werden, die mit unterhalb der Sperrschicht angeordneten elektrischen Kontaktierungselementen elektrisch leitend verbunden sind. Im Anschluss daran wird Werkstoff der Opferschicht oberhalb der Sperrschicht durch Ätzen entfernt, so dass die Bewegbarkeit des mikroelektromechanischen Elements erreicht wird.

Das Silizium oder Aluminiumoxid im Graben kann mittels PE-CVD-Technologie, Sputtern oder Atomlagenbeschichtung (ALD) abgeschieden und die Schicht damit ausgebildet werden.

Die Verwendung von Bor-dotiertem amorphen Silizium aSiB oder, Aluminiumoxid, Germanium oder einer chemischen Verbindung von Silizium und Germanium aSiGe als Werkstoff bietet gegenüber Metallen den Vorteil, besser bzw. vollständig inert gegenüber Flusssäure in flüssiger oder gasförmiger Form zu sein und somit die gewünschte Schutzwirkung während des Releaseprozesses auch über quasi unbegrenzte Zeit zu gewährleisten.

Ein weiterer Vorteil wird durch die Fähigkeit des Siliziums, insbesondere von aSiB, Germanium oder einer chemischen Verbindung von Silizium und Germanium aSiGe Gräben zu verfüllen erreicht. Silizium, Germanium oder eine chemische Verbindung von Silizium und Germanium das/die mittels PE-CVD-Technologie abgeschieden wird, kann einen Graben, der als ringförmiger Schutz vorgesehen ist, vollständig und ohne Leerräume (Voids) ausfüllen. Anschließend kann das Silizium, insbesondere aSiB oder das Germanium oder die chemische Verbindung von Silizium und Germanium aSiGe planarisiert werden. Im Gegensatz dazu werden die bisher eingesetzten und bereits oben genannten Metallschichten mittels PVD-Verfahren abgeschieden und verfüllen dabei Gräben nicht vollständig, sondern lediglich den Boden und die Seitenwände. Die Dicken dieser Schichten sind dabei üblicherweise deutlich dünner als die im unstrukturierten Bereich abgeschiedenen Solldicken. Insbesondere am Übergang von Grabenboden zur Seitenwand liegt eine minimale Schichtdicke vor und durch die dort lokal herrschenden mechanischen Bedingungen kommt es vermehrt zur Bildung von Mikrorissen. Diese stellen neben der geringeren Widerstandsfähigkeit des Werkstoffs ein zusätzliches Leck dar und verringern somit die Schutzwirkung von mit Metall gefüllten Gräben. Derartige Probleme konnten insbesondere an den Ecken von Bauteilen beobachtet werden, an denen durch den notwendigen Krümmungsradius des mit der Schicht gebildeten Schutzrings vermehrt Unterätzungen auftreten. Bei Verwendung von vollständig mit Silizium, insbesondere aSiB , Germanium oder einer mit Silizium und Germanium gebildeten chemischen Verbindung gefüllten Gräben sind dagegen keine Lecks zu erwarten, da die Gesamtbreite und Höhe des mit dem Silizium gefüllten Schutzringes, der mit der Schicht gebildet ist, deutlich breiter und höher ausfällt.

Bei der Herstellung erfindungsgemäßer MEMS-Bauteile kann auf an sich bekannte Verfahren zurückgegriffen werden, wie sie bisher üblich waren.

Nachfolgend soll die Erfindung beispielhaft näher erläutert werden.

Dabei zeigen:
- Figur 1a: eine Schnittdarstellung durch ein Beispiel eines MEMS-Bauteils während dem erfindungsgemäßen Herstellungsverfahren, bei der ein mikromechanisches Element ohne ausreichende Entfernung von Opferschichtwerkstoff noch nicht frei bewegbar ist;
- Figur 1b: eine Schnittdarstellung durch ein weiteres Beispiel eines MEMS-Bauteil während dem erfindungsgemäßen Herstellungsverfahren, bei der ein mikromechanisches Element ohne ausreichende Entfernung von Opferschichtwerkstoff noch nicht frei bewegbar ist;
- Figur 2: eine Schnittdarstellung durch ein Standard CMOS-Schaltkreissubstrat
- Figur 3: eine Schnittdarstellung durch das CMOS-Schaltkreissubstrat, bei dem auf seiner Oberfläche CMOS-Elemente in einen Bereich mit Isolatorschicht aus Siliziumdioxid überdeckt worden sind;
- Figur 4: eine Schnittdarstellung des CMOS-Schaltkreises nach Figur 3, bei dem durch die Isolatorschicht Durchbrechungen (Vias) ausgebildet worden sind;
- Figur 5: eine Schnittdarstellung des Beispiels nach Figur 4, bei dem eine Metallisierung und Strukturierung des Metalls zur Ausbildung elektrischer Durchkontaktierungen auf den CMOS und elektrischen Kontaktierungselementen durchgeführt worden ist;
- Figur 6: eine Schnittdarstellung durch ein Beispiel nach Figur 5, bei der durch die Durchbrechungen elektrische Durchkontaktierungen (Vias) am radial äußeren Rand um die Elemente des CMOS-Schaltkreises ein radial umlaufender Graben bis auf den Siliziumwafer ausgebildet worden ist;
- Figur 7: eine Schnittdarstellung des CMOS-Schalkreises mit der Isolatorschicht nach Figur 6, bei der die Oberfläche mit aSiB beschichtet und dabei der Graben mit aSiB ausgefüllt worden ist;
- Figur 8: eine Schnittdarstellung des in Figur 7 gezeigten Beispiels, bei der ein Teil des abgeschiedenen aSiB bis auf den Grabenbereich wieder entfernt worden ist;
- Figur 9: eine Schnittdarstellung des Beispiels nach Figur 8, bei der ein weiterer Bereich mit einer Isolatorschicht aus Siliziumdioxid auf der Oberfläche, den mit aSiB ausgefüllten Graben überdeckend, ausgebildet worden ist;
- Figur 10: eine Schnittdarstellung des Beispiels nach Figur 9, bei dem die Oberfläche der Isolatorschicht planarisiert worden ist;
- Figur 11: eine Schnittdarstellung des Beispiels nach Figur 10, bei dem auf der planarisierten Oberfläche ein Durchbruch (Via) geformt und in diesen sowie auf der Oberfläche eine Metallschicht mit Kontakt zur Siliziumschicht ausgebildet worden ist;
- Figur 12: eine Schnittdarstellung des Beispiels nach Figur 11, bei dem durch lokal definierte Entfernung der Metallschicht elektrische Kontaktierungselemente und elektrische Leiterbahnen ausgebildet worden sind;
- Figur 13: eine Schnittdarstellung des Beispiels nach Figur 12, bei dem ein weiterer Bereich der Isolatorschicht ausgebildet und die elektrischen Kontaktierungselemente darin eingebettet worden sind;
- Figur 14: eine Schnittdarstellung des Beispiels nach Figur 13, bei dem eine Planarisierung der Oberfläche der Isolatorschicht durchgeführt worden ist;
- Figur 15: eine Schnittdarstellung des Beispiels nach Figur 14, bei dem auf die planarisierte Oberfläche der Opferschicht eine Sperrschicht aus Aluminiumoxid oder aSi ausgebildet worden ist;
- Figur 16: eine Schnittdarstellung des Beispiels nach Figur 15, bei dem durch die Sperrschicht aus Aluminiumoxid oder aSi lokal definiert Durchbrechungen ausgebildet worden sind;
- Figur 17: eine Schnittdarstellung des Beispiels nach Figur 16, bei dem die Durchbrechungen bis zu elektrischen Kontaktierungselementen, die innerhalb der Isolatorschicht angeordnet sind, geführt worden sind;
- Figur 18: eine Schnittdarstellung des Beispiels nach Figur 17, bei dem eine Metallisierung auf der Oberfläche aufgebracht und elektrische Durchkontaktierungen bis zu den elektrischen Kontaktierungselementen ausgebildet worden ist;
- Figur 19: eine Schnittdarstellung des Beispiels nach Figur 18, bei dem die finale Metallisierung lokal definiert entfernt worden ist;
- Figur 20: eine Schnittdarstellung des Beispiels nach Figur 19, bei dem auf der Oberfläche des metallisierten CMOS-Schaltkreises eine Opferschicht für das MEMS-Element ausgebildet worden ist;
- Figur 21: eine Schnittdarstellung des Beispiels nach Figur 20, bei dem die Oberfläche der Opferschicht planarisiert worden ist;
- Figur 22: eine Schnittdarstellung des Beispiels nach Figur 21, bei dem in dem vorab ausgebildeten Bereich der Opferschicht eine Durchbrechung bis zu einem elektrischen Kontaktierungselement ausgebildet worden ist;
- Figur 23: eine Schnittdarstellung des Beispiels nach Figur 22, bei dem auf der planarisierten Oberfläche des vorab aufgetragenen Bereiches der Opferschicht bis in die zuletzt ausgebildete Durchbrechung Werkstoff für die Ausbildung eines mikroelektromechanischen Elements aufgebracht worden ist;
- Figur 24: eine Schnittdarstellung des Beispiels nach Figur 23, bei dem ein lokal definierter Werkstoffabtrag des Werkstoffs für die Ausbildung eines mikroelektromechanischen Elements durchgeführt worden ist und
- Figur 25: eine Schnittdarstellung durch ein fertig hergestelltes Beispiel eines erfindungsgemäßen MEMS-Bauteils, bei dem ein Bereich der Opferschicht entfernt worden ist, so dass das mikroelektromechanische Element bewegbar ist.

Mit den nachfolgenden Figuren soll verdeutlicht werden, wie ein Beispiel eines erfindungsgemäßen MEMS-Bauteils sukzessive in Verfahrensschritten hergestellt werden kann.

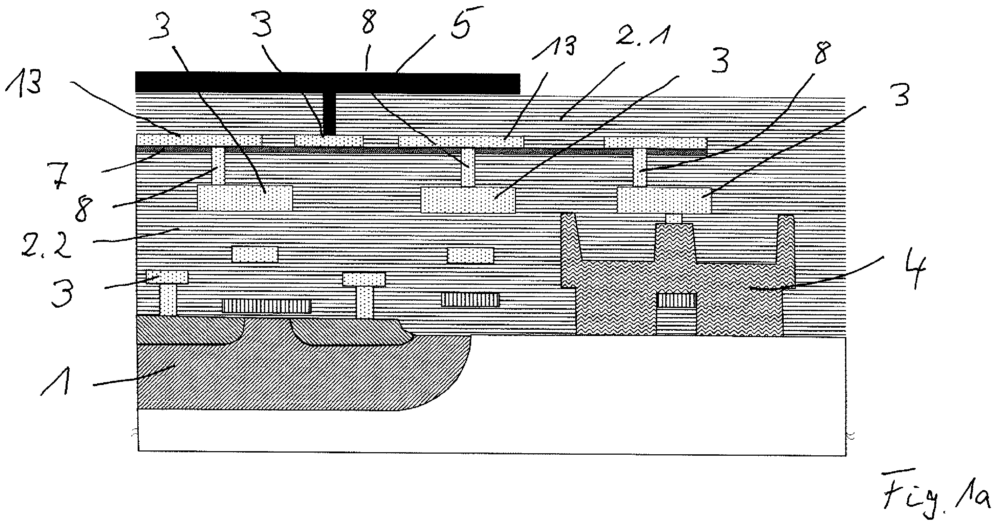

In Figur 1a ist ein Beispiel gezeigt, bei dem ein mikromechanisches Element 5 noch nicht frei bewegbar ist. Dabei sind auf der Oberfläche eines CMOS-Schaltkreissubstrates 1 eine Opferschicht 2.1 im oberen Bereich des MEMS-Bauteils, der zur Erreichung der Bewegbarkeit des MEMs-Elements 5 entfernt werden soll und darunter eine Isolatorschicht 2.2 im Bereich des CMOS-Schaltkreises aus Siliziumdioxid ausgebildet, in der mehrere elektrische Kontaktierungselemente 3 eingebettet sind. Am radial äußeren Rand des MEMS-Bauteils ist eine Schicht 4 aus aSiB umlaufend auf der Oberfläche des CMOS-Schaltkreissubstrates 1 ausgebildet und an den anderen Oberflächen von Opfer- und Isolatorschichtwerkstoff umschlossen.

In einem Abstand zur Oberfläche der Opferschicht 2.1, an der das mikroelektromechanische Element 5 hier noch anliegt ist eine Sperrschicht 7 aus Aluminiumoxid ausgebildet, die Durchbrechungen aufweist, durch die elektrische Durchkontaktierungen 8 zu elektrischen Kontaktierungselementen 3 geführt sind. Das mikroelektromechanische Element 5 soll bei diesem Beispiel ein verschwenkbares elektromagnetische Strahlung reflektierendes Element sein.

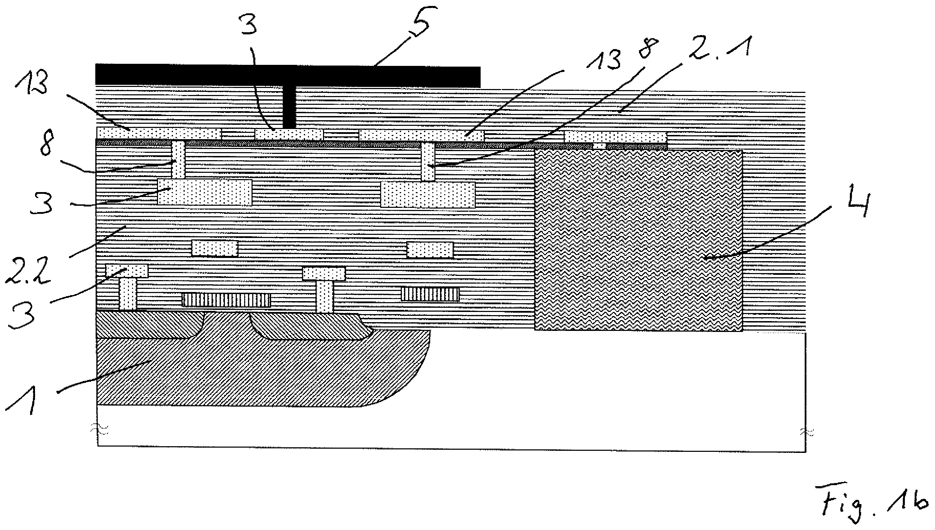

Das in Figur 1b gezeigte Beispiel unterscheidet sich vom Beispiel nach Figur 1a lediglich durch die Art und Weise der Ausbildung der Schicht 4. Diese ist bis an die Sperrschicht 7 geführt.

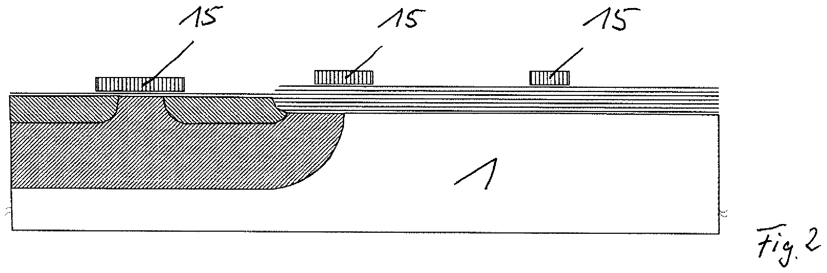

Figur 2 zeigt als Ausgangspunkt für die Herstellung ein standardmäßig verfügbares CMOS-Schaltkreissubstrat 1 mit CMOS-Elementen 15.

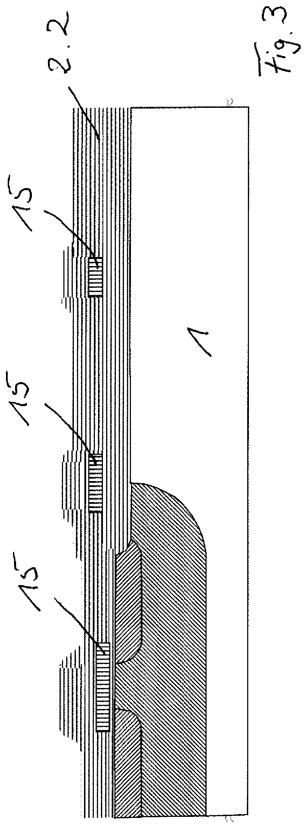

In Figur 3 ist gezeigt, wie auf der Oberfläche des CMOS-Schaltkreissubstrates 1 ein Bereich einer Isolatorschicht 2.2 aus Siliziumdioxid mittels eines PE-CVD-Verfahrens abgeschieden worden ist.

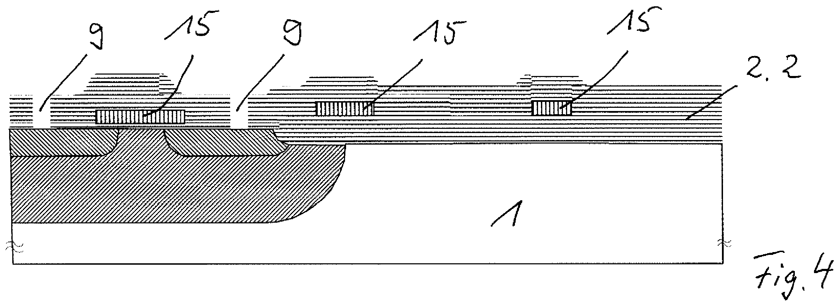

In die so ausgebildete Opferschicht 2 wurden lokal definiert Kontaktlöcher (Vias) 9 mittels reaktivem Ionen Ätzen ausgebildet, die von der Oberfläche des bis hierhin ausgebildeten Bereichs der Isolatorschicht 2.2 bis zu elektrischen Kontakten der CMOS-Schaltkreissubstrates 1 geführt sind (Figur4).

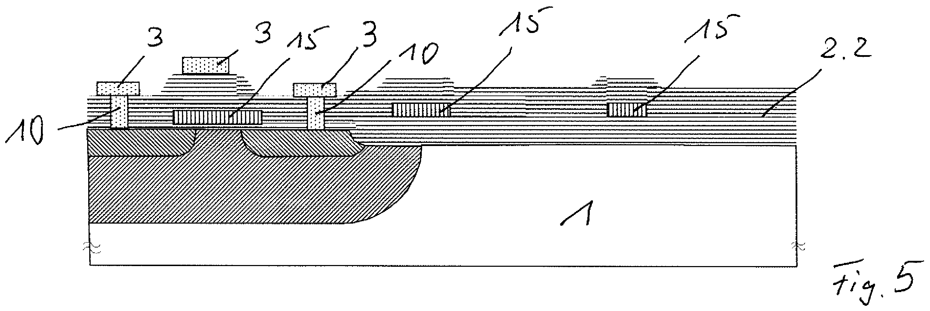

Durch eine Abscheidung eines Metalls durch Sputtern und durch lithografische Strukturierung wurden weitere elektrische Kontaktierungen 3 und elektrische Durchkontaktierungen 10 ausgebildet, was man Figur 5 entnehmen kann.

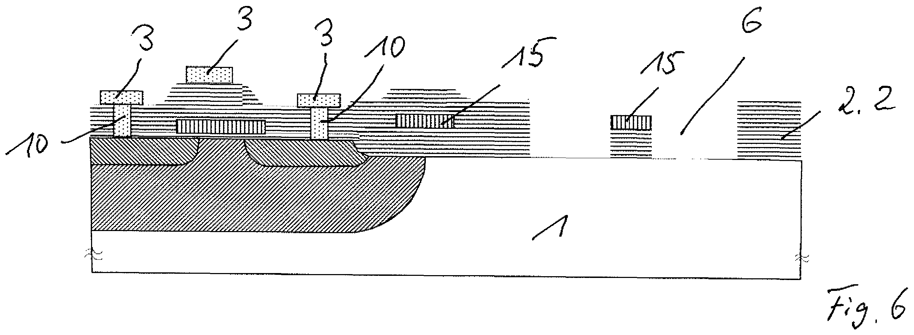

In Figur 6 ist gezeigt, wie das in Figur 5 gezeigte Halbzeug weiter bearbeitet worden ist, indem am radial äußeren Rand des MEMS-Bauteils im Werkstoff der Isolatorschicht 2.2 ein radial umlaufender Graben 6 durch reaktives Ionenätzen ausgebildet worden ist, der bis an die Oberfläche des CMOS-Schaltkreissubstrates 1 reicht.

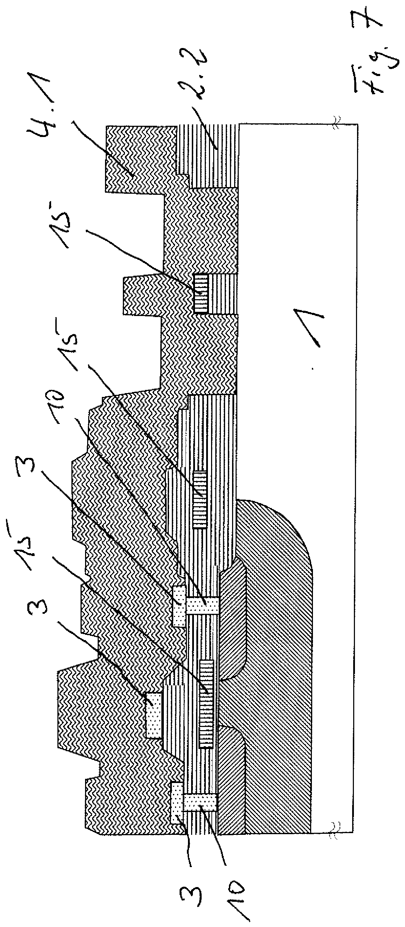

Aus Figur 7 kann man entnehmen, wie die gesamte Oberfläche mit aSiB 4.1 durch ein PE-CVD-Verfahren beschichtet worden ist. Dabei wurde auch der Graben 6 vollständig mit dem aSiB 4.1 befüllt.

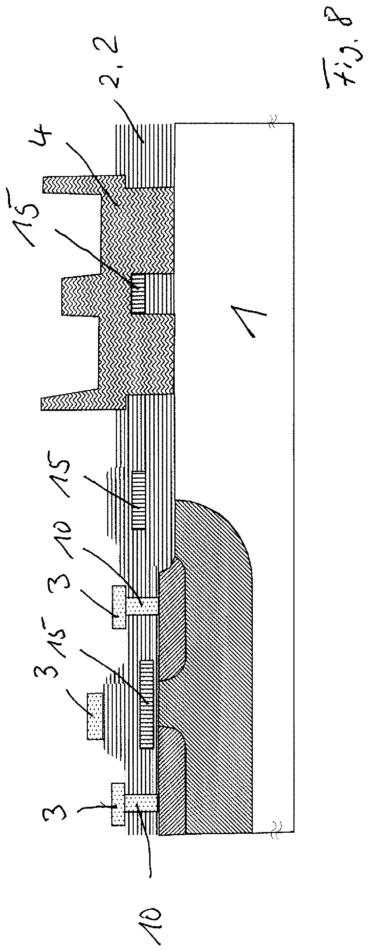

Im Anschluss darin wurde aSiB 4.1 lokal definiert lithografisch und durch reaktives Ionenätzen lokal definiert entfernt, so dass diese nur noch im Bereich des späteren Schutzringes als Schicht 4 verbleibt, was man Figur 8 entnehmen kann. Die Oberfläche der Schicht 4 muss nicht so strukturiert, wie bei diesem Beispiel ausgebildet sein, sie kann auch eben und planar sein, wie dies in Figur 1b gezeigt ist.

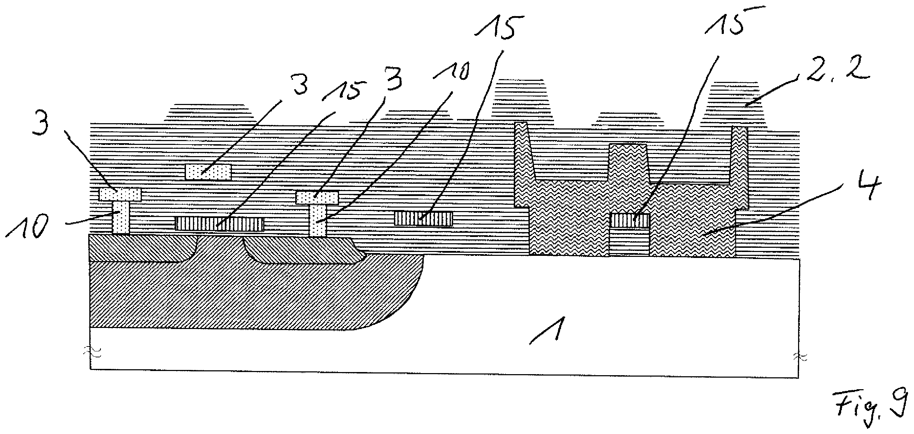

Wiederum im Anschluss daran wurde wieder ein Bereich der Isolatorschicht 2.2 mit einem PE-CVD-Verfahren abgeschieden, so dass die Oberfläche vollständig mit dem Siliziumdioxid gebildet und auch die Schicht 4 damit überdeckt ist (Figur 9).

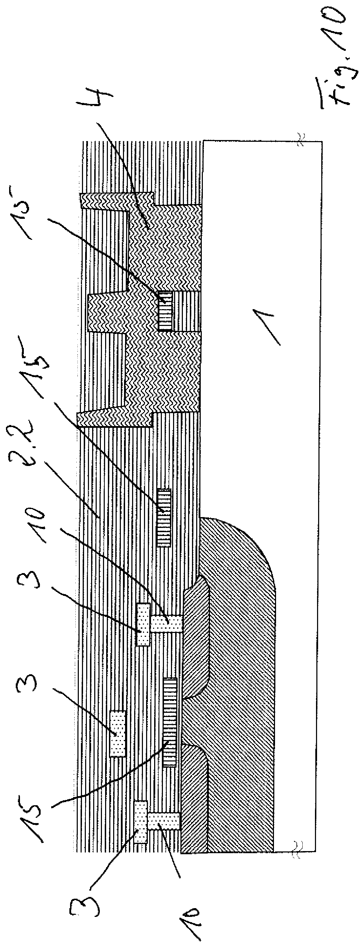

Figur 10 zeigt, wie die Oberfläche der bis dahin ausgebildeten Isolatorschicht 2.2 und das die Schicht 4 bildende aSiB mittels chemisch-mechanischem Polieren planarisiert worden ist.

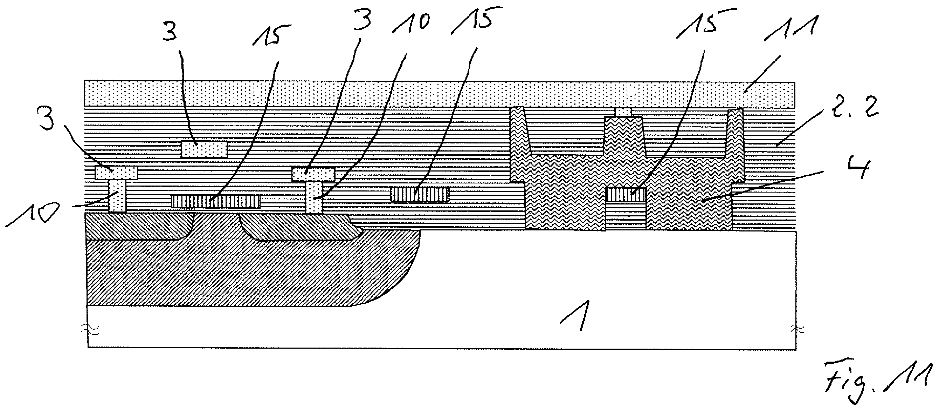

Auf die planarisierte Oberfläche der bis dahin ausgebildeten Isolatorschicht 2.2 wurde ein Via 10 geätzt und durch Sputtern eine durchgehende und das aSiB in der Schicht 4 kontaktierende Schicht 11 aus AlSiCu ausgebildet (Figur 11).

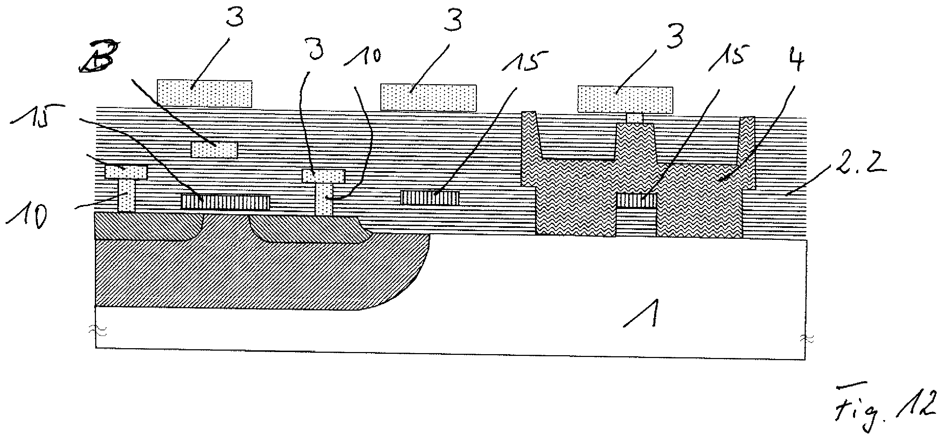

Figur 12 kann man entnehmen, wie lithografisch und durch Ätzen ein Teil der Schicht 11 lokal definiert entfernt worden und damit elektrische Kontaktierungselemente bzw. Leiterbahnen 3 ausgebildet worden sind.

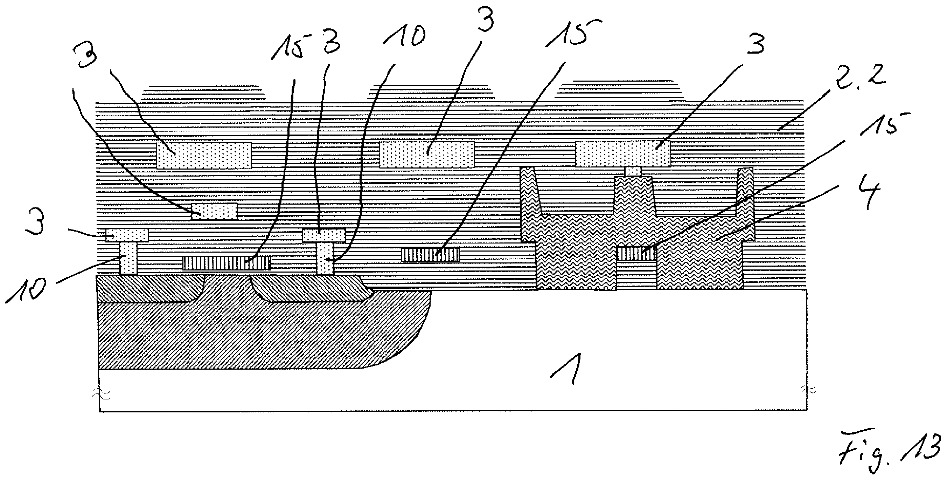

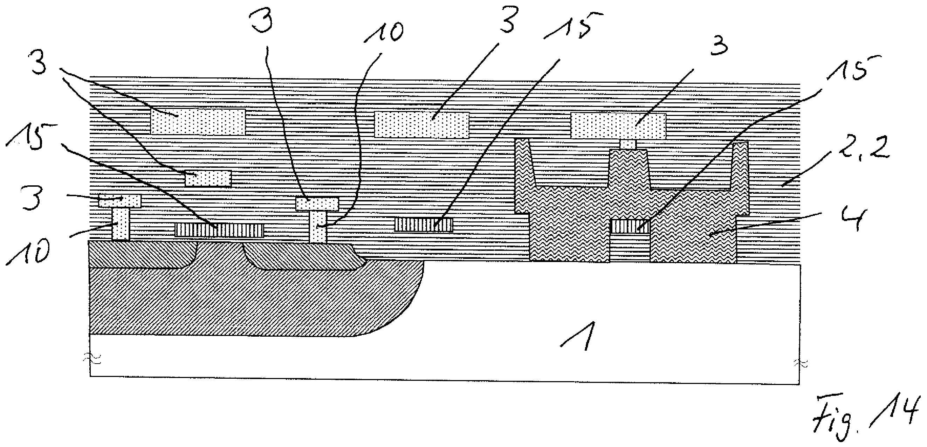

Den Figuren 13 und 14 kann man entnehmen, dass ein weiterer Bereich der Isolatorschicht 2.2 durch ein PE-CVD-Verfahren auf der Oberfläche ausgebildet und die zuletzt hergestellten elektrischen Kontaktierungselemente 3 darin eingebettet werden. Anschließend erfolgte wieder eine Planarisierung der Oberfläche der Isolatorschicht 2.2 durch chemisch-mechanisches Polieren.

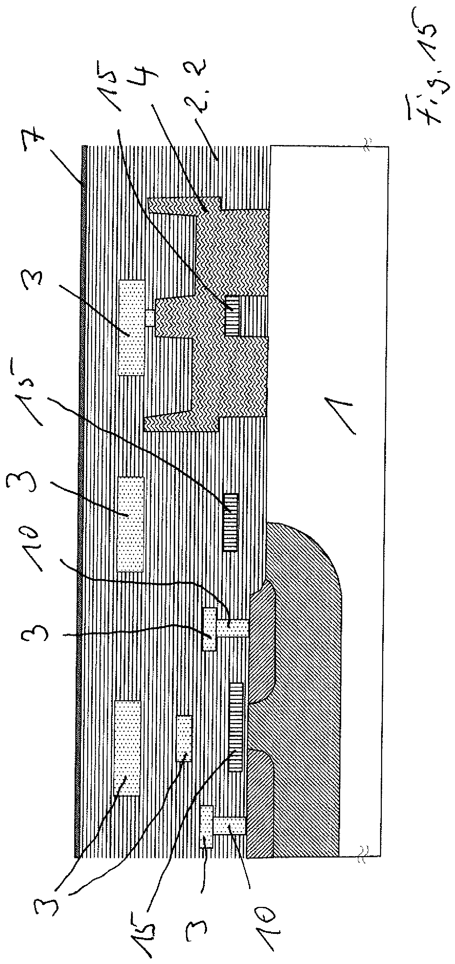

Figur 15 zeigt die Ausbildung einer Sperrschicht 7 aus Aluminiumoxid auf der gesamten Oberfläche der Isolatorschicht 2.2. Die Sperrschicht 7 kann mittels ALD (atomic layer deposition) ausgebildet werden. Sie sollte eine geschlossene Schicht bilden.

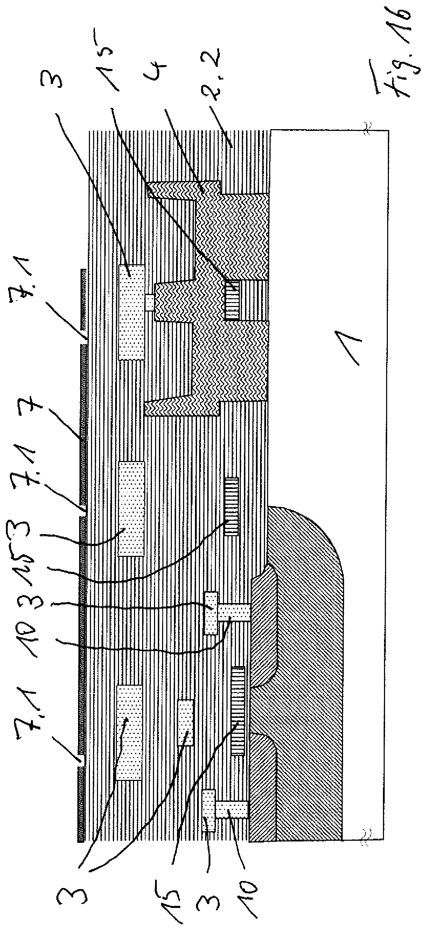

Gemäß Figur 16 werden in die Sperrschicht 7 lokal definiert mittels reaktivem Ionenätzen Durchbrechungen 7.1 ausgebildet.

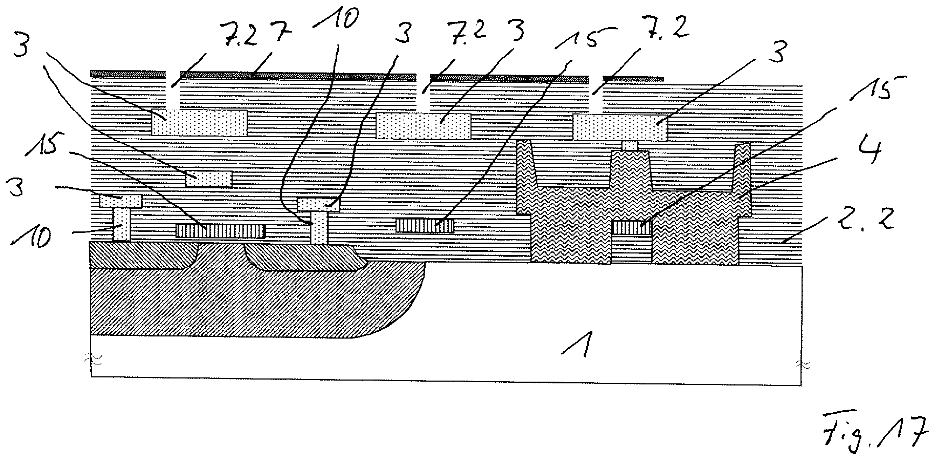

Die Durchbrechungen 7.1 können mittels reaktivem Ionenätzen und dabei lokal definierter Entfernung von Isolatorschichtwerkstoff weiter vertieft werden, so dass die vergrößerten Vias 7.2 ausgebildet werden können, die bis zu elektrischen Kontaktierungselementen 3 geführt sind. Dies ist in Figur 17 dargestellt.

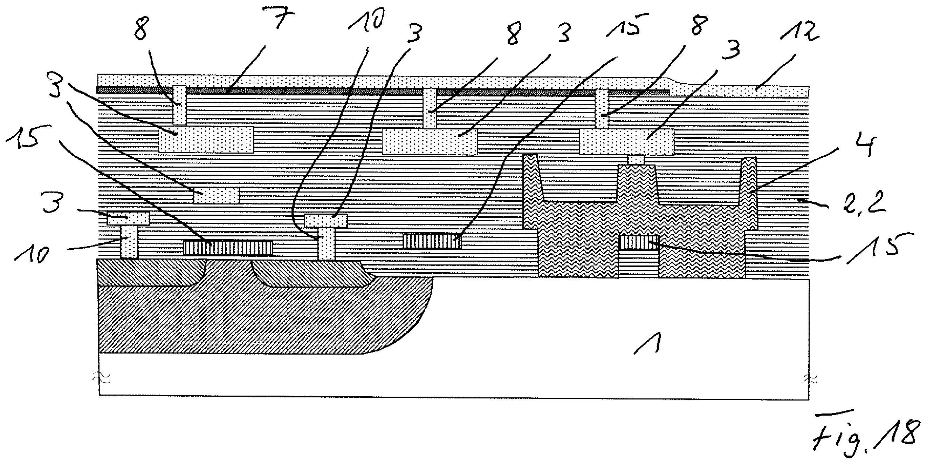

Gemäß Figur 18 wird auf die Oberfläche wieder eine Metallschicht 12 durch Sputtern aufgebracht, mit der Durchkontaktierungen 8 zu den vorab letzten ausgebildeten elektrischen Kontaktierungselementen 3 ausgebildet werden. Es kann dazu wieder die AlSiCu-Legierung oder TiAl eingesetzt werden.

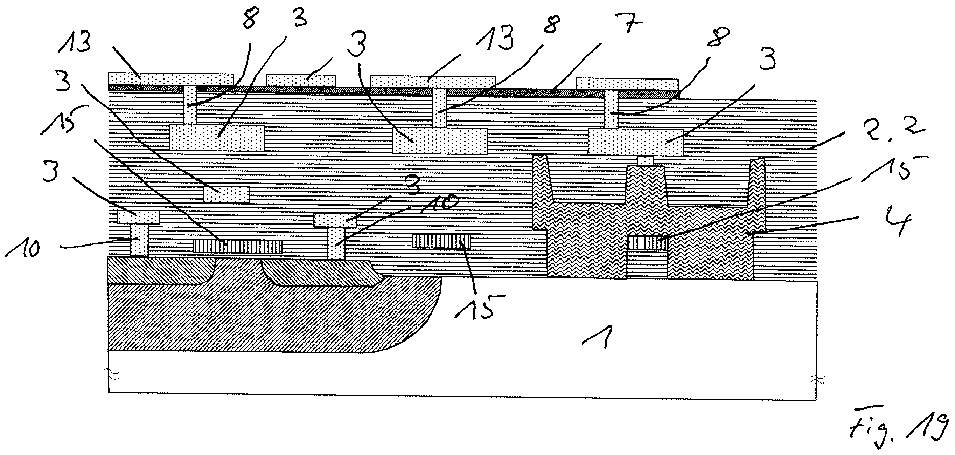

Mit Figur 19 soll verdeutlicht werden, wie lithografisch und mittels Ätzen ein lokal definierter Abtrag der Metallschicht 12 erfolgen soll, der zur Ausbildung weiterer elektrischer Kontaktierungselemente 3 sowie Elektroden 13 auf der Oberfläche der Sperrschicht 7 führt.

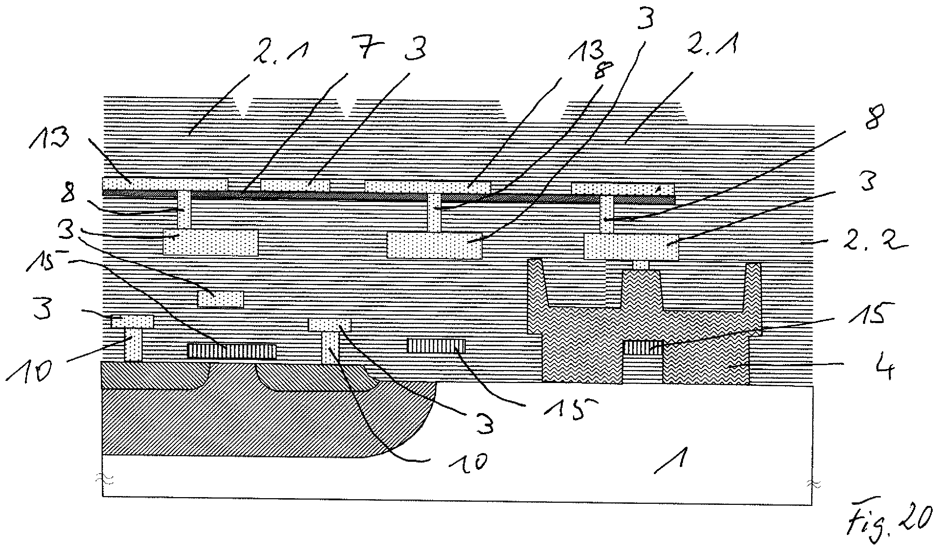

Für die Ausbildung eines mikroelektromechanischen Elements 5 wird dann weiterer Opferschichtwerkstoff mittels PE-CVD-Technik auf der Oberfläche abgeschieden, so dass darin die zuletzt ausgebildeten elektrischen Kontaktierungselemente 3, die Elektroden 13 und die Sperrschicht 7 vom Werkstoff der Opferschicht 2.1 umschlossen sind (Fig. 20).

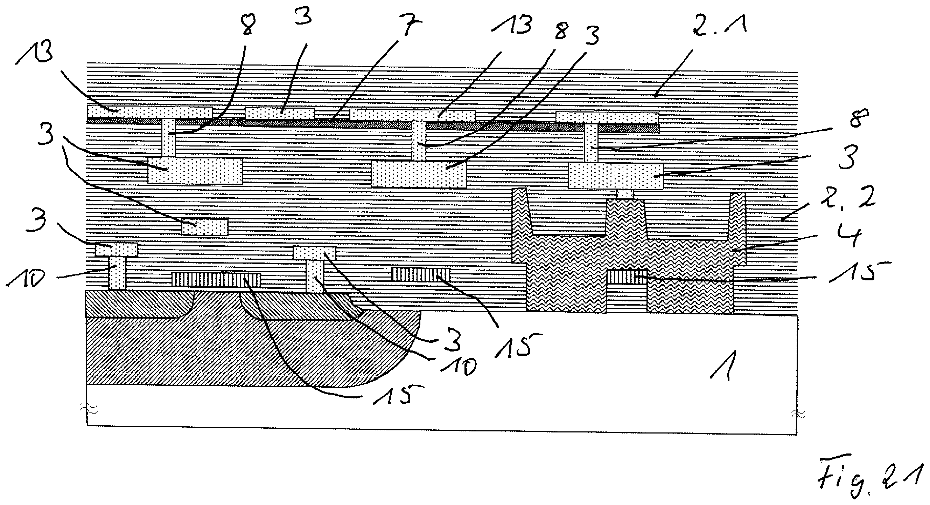

Gemäß Figur 21 wird die Oberfläche der Opferschicht 2.1 wieder mit chemisch-mechanischem Polieren planarisiert.

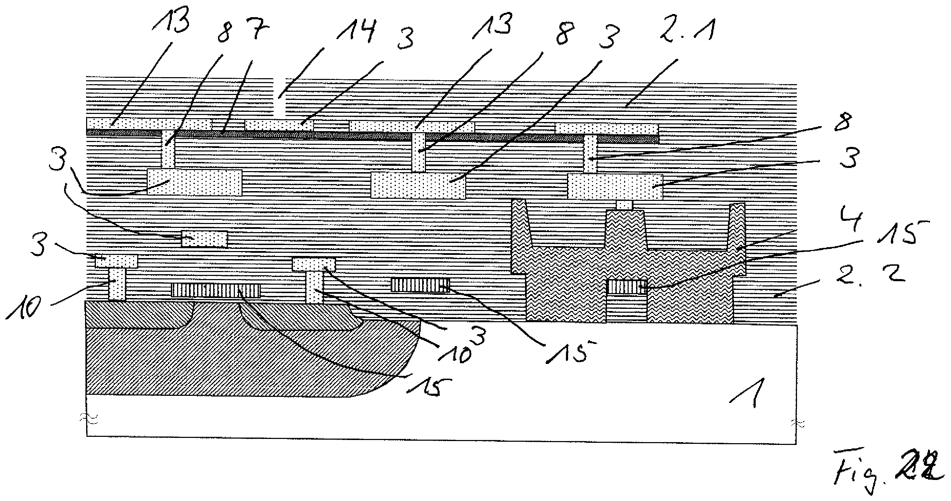

Figur 22 kann man entnehmen, dass eine weitere Durchbrechung 14 durch den Opferschichtwerkstoff ausgehend von der Oberfläche bis zu einem in der Opferschicht 2.1 eingebetteten und oberhalb der Sperrschicht 7 angeordneten elektrischen Kontaktierungselement 3 durch reaktives Ionenätzen ausgebildet wird.

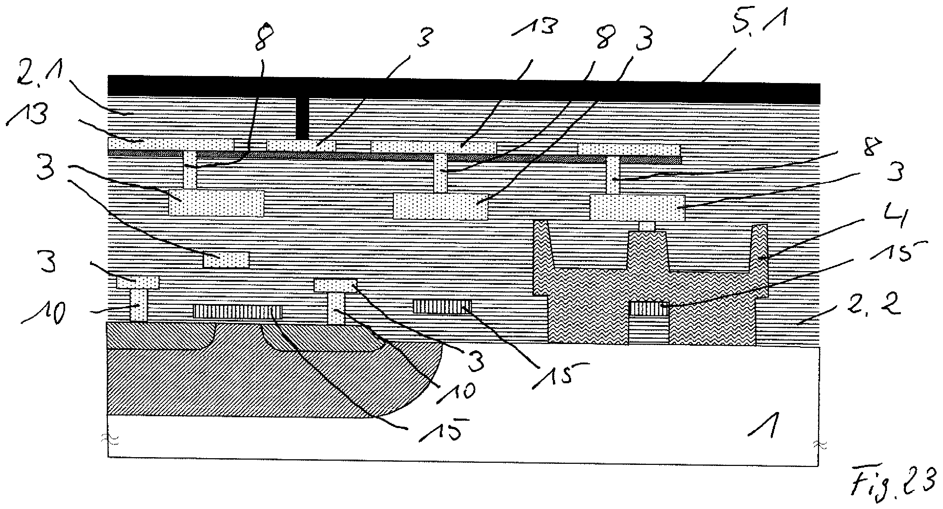

Im Anschluss daran wird eine Schicht des Werkstoffs 5.1 mit dem das mikroelektromechanische Element 5 ausgebildet werden soll ausgebildet und mit dem Werkstoff 5.1 die Durchbrechung 14 mit ausgefüllt, so dass bei einem elektrisch leitenden Werkstoff für ein mikroelektromechanisches Element 5 eine elektrisch leitende Verbindung zu dem entsprechenden elektrischen Kontaktierungselement 3 hergestellt werden kann. Bei einem Metall kann die Ausbildung der Schicht durch Sputtern und bei anderen Werkstoffen, wie beispielsweise Silizium durch ein PE-CVD-Verfahren ausgebildet werden (Figur 23).

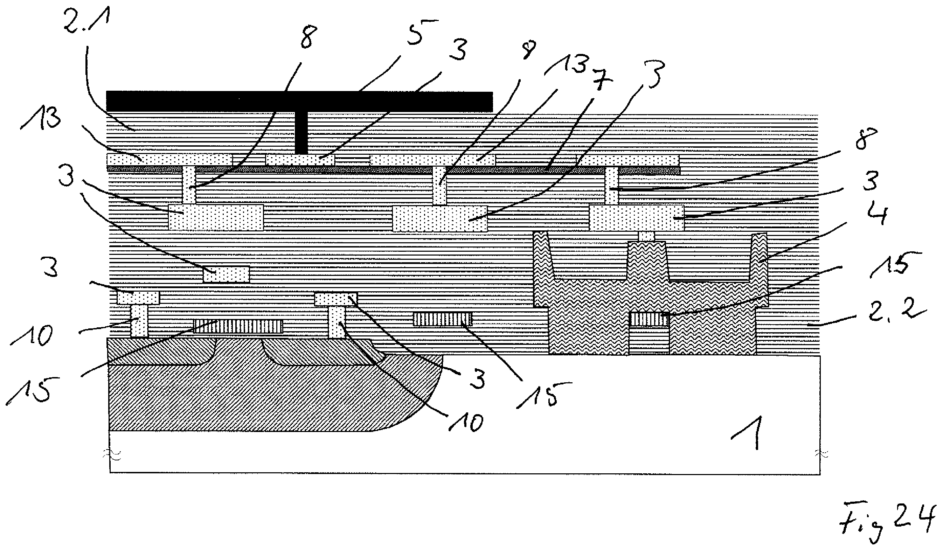

Mittels Lithografie und Ätzen kann ein Teil des Werkstoffs mit dem das mikroelektromechanische Element 5 ausgebildet werden soll, wieder entfernt werden, wodurch die Dimensionierung und geometrische Gestalt des mikroelektromechanischen Elements 5 beeinflusst werden kann (Figur 24).

Im Anschluss daran wird an der Oberfläche Opferschichtwerkstoff durch Nass- oder Gasphasenätzen mit Flusssäure entfernt, so dass das in diesem Fall als verschwenkbares reflektierendes Element ausgebildete mikroelektromechanische Element 5 um mindestens eine Achse frei beweglich verschwenkbar ist. Dabei kann auch ein Teil der Schicht 4 am äußeren Rand freigelegt werden, was aber nicht sein muss.

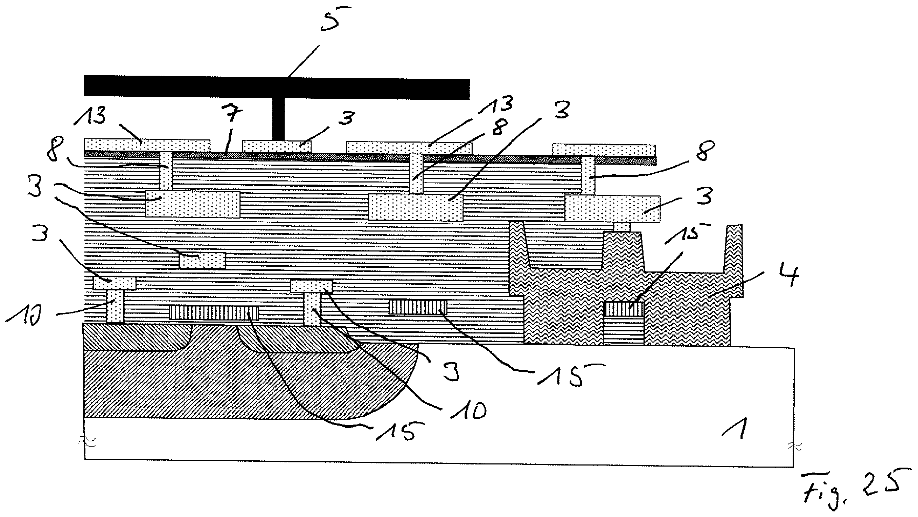

Ein so prozessiertes Beispiel eines erfindungsgemäßen MEMS-Bauteils kann man Figur 25 entnehmen.

## Patentansprüche

1. Mikroelektromechanisches Bauteil, bei dem mindestens ein mikroelektromechanisches Element (5), elektrische Kontaktierungselemente (3) und eine Isolationsschicht (2.2) auf einer Oberfläche eines CMOS-Schaltkreissubstrates (1) ausgebildet sind und das mikroelektromechanische Element (5) in mindestens einem Freiheitsgrad frei beweglich angeordnet ist, **dadurch gekennzeichnet, dass** am äußeren Rand des mikroelektromechanischen Bauteils, radial um alle Elemente des CMOS-Schaltkreises umlaufend, eine gegenüber Flusssäure resistente, gas- und/oder fluiddichte geschlossene Schicht (4), die mit Silizium, Germanium oder Aluminiumoxid gebildet ist, auf der Oberfläche des CMOS-Schaltkreissubstrates (1) ausgebildet ist.

2. Bauteil nach Anspruch 1, **dadurch gekennzeichnet, dass** die Schicht (4) mit amorphem Silizium gebildet ist.

3. Bauteil nach einem der vorhergehenden Ansprüche, **dadurch gekennzeichnet, dass** die Schicht (4) mit dotiertem amorphen Silizium, insbesondere mit Bor oder Germanium dotiertem amorphen Silizium oder einer chemischen Verbindung von Silizium und Germanium gebildet ist.

4. Bauteil nach einem der vorhergehenden Ansprüche, **dadurch gekennzeichnet, dass** an der Oberfläche des mikroelektromechanischen Bauteils an der das mikroelektromechanische Element (5) beweglich angeordnet ist, eine Sperrschicht (7) aus Aluminiumoxid ausgebildet ist.

5. Bauteil nach einem der vorhergehenden Ansprüche, **dadurch gekennzeichnet, dass** die Schicht (4) mit mindestens einer weiteren Schicht überbeschichtet ist, wobei die mindestens eine weitere Schicht bevorzugt mit einem Metall, besonders bevorzugt mit Titan, Aluminium, Aluminiumkupferlegierung oder einer Titanaluminiumlegierung oder Titannitrid gebildet ist.

6. Verfahren zur Herstellung eines mikroelektromechanischen Elements nach einem der vorhergehenden Ansprüche, **dadurch gekennzeichnet, dass** auf einer Oberfläche des CMOS-Schaltkreissubstrates (1) eine Isolatorschicht (2.2) mit Siliziumdioxid aufgebracht und in die Isolatorschicht (2.2) dabei lokal definiert elektrische Kontaktierungselemente (3) eingebettet werden und
in der Isolatorschicht (2.2) am äußeren Rand mindestens ein bis zu der Oberfläche des CMOS-Schaltkreissubstrates (1) reichender Graben (6) radial um alle Elemente des CMOS-Schaltkreises umlaufend ausgebildet wird; und
der Graben (6) zumindest in seinem Bodenbereich mit einer geschlossenen Schicht (4), die mit Silizium, Germanium, einer chemischen Verbindung von Silizium und Germanium oder Aluminiumoxid gebildet ist, ausgefüllt wird; und
im Anschluss daran eine Opferschicht (2.1) mit Siliziumdioxid und darauf ein Werkstoff aufgebracht wird, mit dem mindestens ein mikromechanisches Element (5) ausgebildet wird und dann
mit einem Ätzverfahren die Opferschicht (2.1) lokal definiert mit Flusssäure entfernt wird, so dass eine Bewegbarkeit des mindestens einen mikroelektromechanischen Elements (5) erreicht wird.

7. Verfahren nach dem vorhergehenden Anspruch, **dadurch gekennzeichnet, dass** der Graben (6) überwiegend, bevorzugt vollständig mit Silizium, Germanium oder Aluminiumoxid ausgefüllt wird.

8. Verfahren nach Anspruch 6, **dadurch gekennzeichnet, dass** die Schicht (4) mit mindestens einer weiteren Schicht, die bevorzugt mit einem Metall, besonders bevorzugt mit Titan, Titanaluminium oder Aluminium, Kupfer oder Titannitrid gebildet ist, im Graben (6) überdeckt wird.

9. Verfahren nach einem der beiden vorhergehenden Ansprüche,
**dadurch gekennzeichnet, dass** in der Opferschicht (2) eine geschlossene Sperrschicht (7) aus Aluminiumoxid und auf der in Richtung des mindestens einen mikroelektromechanischen Elements (5) weisenden Oberfläche der Sperrschicht (7) weitere elektrische Kontaktelemente (3) und/oder Elektroden (13), die für die Betätigung des mikroelektromechanischen Elements (5) erforderlich sind, ausgebildet werden, die mit unterhalb der Sperrschicht (7) angeordneten elektrischen Kontaktierungselementen (3) elektrisch leitend verbunden sind, und
im Anschluss daran Werkstoff der Opferschicht (2.1) oberhalb der Sperrschicht (7) durch Ätzen entfernt wird, so dass die Bewegbarkeit des mikroelektromechanischen Elements (5) erreicht wird.

10. Verfahren nach einem der drei vorhergehenden Ansprüche, **dadurch gekennzeichnet, dass** zur lokal definierten Entfernung des Werkstoffs, mit dem die Opferschicht (2.1) gebildet wird, zum Ätzen Flusssäure als Flüssigkeit oder Gas eingesetzt wird.

11. Verfahren nach einem der vier vorhergehenden Ansprüche, **dadurch gekennzeichnet, dass** Silizium oder das Aluminiumoxid im Graben (6) mittels PE-CVD-Technologie, Sputtern, oder ALD abgeschieden und die Schicht (4) damit ausgebildet wird.

## Claims

1. A microelectromechanical component in which at least one microelectromechanical element (5), electrical contacting elements (3), and an insulating layer (2.2) are formed on a surface of a CMOS circuit substrate (1), and the microelectromechanical element (5) is arranged so as to be freely movable in at least one degree of freedom,
**characterized in that**, at the outer edge of the microelectromechanical component, extending radially around all elements of the CMOS circuit, a gas-tight and/or fluid-tight, closed layer (4) that is resistant to hydrofluoric acid and formed from silicon, germanium, or aluminum oxide is formed on the surface of the CMOS circuit substrate (1).

2. The component according to claim 1, **characterized in that** the layer (4) is formed from amorphous silicon.

3. The component according to any one of the preceding claims, **characterized in that** the layer (4) is formed from doped amorphous silicon, and in particular from boron-doped or germanium-doped amorphous silicon, or a chemical compound of silicon and germanium.

4. The component according to any one of the preceding claims, **characterized in that** a barrier layer (7) made of aluminum oxide is formed on the surface of the microelectromechanical component on which the microelectromechanical element (5) is movably arranged.

5. The component according to any of the preceding claims, **characterized in that** the layer (4) is overcoated with at least one further layer, the at least one further layer preferably being formed from a metal, and particularly preferably from titanium, aluminum, an aluminum copper alloy, a titanium aluminum alloy, or titanium nitride.

6. A method for producing a microelectromechanical element according to any one of the preceding claims, **characterized in that** an insulator layer (2.2) comprising silicon dioxide is applied to a surface of the CMOS circuit substrate (1), and electrical contacting elements (3) are embedded in the insulator layer (2.2) in a locally defined manner, and
in the insulator layer (2.2), at the outer edge, at least one trench (6) extending to the surface of the CMOS circuit substrate (1) is formed, extending radially around all elements of the CMOS circuit; and
the trench (6) is filled, at least in the bottom region thereof, with a closed layer (4) formed from silicon, germanium, a chemical compound of silicon and germanium, or aluminum oxide; and
subsequently, a sacrificial layer (2.1) comprising silicon dioxide is applied, followed by a material that is used to form at least one micromechanical element (5); and then
the sacrificial layer (2.1) is removed in a locally defined manner using hydrofluoric acid in an etching process, so that movability of the at least one micromechanical element (5) is achieved.

7. The method according to the preceding claim, **characterized in that** the trench (6) is predominantly, and preferably completely, filled with silicon, germanium, or aluminum oxide.

8. The method according to claim 6, **characterized in that** the layer (4) is covered in the trench (6) with at least one further layer, which is preferably formed from a metal, and particularly preferably from titanium, titanium aluminum, aluminum, copper, or titanium nitride.

9. The method according to any one of the two preceding claims, **characterized in that** a closed barrier layer (7) made of aluminum oxide is formed in the sacrificial layer (2), and, on the surface of the barrier layer (7) facing in the direction of the at least one microelectromechanical element (5), further electrical contact elements (3) and/or electrodes (13) that are required for the actuation of the microelectromechanical element (5) are formed, which are electrically conductively connected to electrical contacting elements (3) arranged beneath the barrier layer (7), and subsequently, material of the sacrificial layer (2.1) above the barrier layer (7) is removed by etching, so that the movability of the microelectromechanical element (5) is achieved.

10. The method according to any one of the three preceding claims, **characterized in that** hydrofluoric acid, in liquid or gaseous form, is used for etching to remove the material used to form the sacrificial layer (2.1) in a locally defined manner.

11. The method according to any one of the four preceding claims, **characterized in that** silicon or aluminum oxide is deposited in the trench (6) using PE-CVD technology, sputtering, or ALD, thereby forming the layer (4).

## Revendications

1. Composant microélectromécanique dans lequel au moins un élément microélectromécanique (5), des éléments de contact électrique (3) et une couche isolante (2.2) sont formés sur une surface d'un substrat de circuit CMOS (1) et l'élément microélectromécanique (5) est agencé de manière à pouvoir bouger librement selon au moins un degré de liberté,
**caractérisé en ce qu'**une couche fermée (4) résistante à l'acide fluorhydrique, étanche aux gaz et/ou aux fluides, constituée de silicium, de germanium ou d'oxyde d'aluminium, est formée sur la surface du substrat de circuit CMOS (1) au niveau du bord extérieur du composant microélectromécanique, en entourant radialement tous les éléments du circuit CMOS.

2. Composant selon la revendication 1, **caractérisé en ce que** la couche (4) est constituée de silicium amorphe.

3. Composant selon l'une quelconque des revendications précédentes, **caractérisé en ce que** la couche (4) est constituée de silicium amorphe dopé, en particulier de silicium amorphe dopé au bore ou au germanium ou d'un composé chimique de silicium et de germanium.

4. Composant selon l'une quelconque des revendications précédentes, **caractérisé en ce qu'**une couche barrière (7) en oxyde d'aluminium est formée sur la surface du composant microélectromécanique sur lequel l'élément microélectromécanique (5) est agencé de manière mobile.

5. Composant selon l'une quelconque des revendications précédentes, **caractérisé en ce que** la couche (4) est recouverte d'au moins une couche supplémentaire, dans lequel ladite au moins une couche supplémentaire est de manière préférée constituée d'un métal, de manière particulièrement préférée de titane, d'aluminium, d'un alliage aluminium-cuivre ou d'un alliage titane-aluminium ou de nitrure de titane.

6. Procédé de fabrication d'un élément microélectromécanique selon l'une quelconque des revendications précédentes, **caractérisé en ce qu'**une couche isolante (2.2) comprenant du dioxyde de silicium est appliquée sur une surface du substrat de circuit CMOS (1) et **en ce que** des éléments de contact électrique (3) sont intégrés dans la couche isolante (2.2) de manière localement définie et
au moins une tranchée (6) atteignant la surface du substrat du circuit CMOS (1) est formée dans la couche isolante (2.2) au niveau du bord extérieur de manière à entourer radialement tous les éléments du circuit CMOS ; et
la tranchée (6) est remplie, au moins dans sa région inférieure, avec une couche fermée (4) constituée de silicium, de germanium, d'un composé chimique de silicium et de germanium ou d'oxyde d'aluminium ; et
une couche sacrificielle (2.1) de dioxyde de silicium est ensuite appliquée, puis un matériau, grâce auquel au moins un élément micromécanique (5) est formé, est déposé par-dessus, et ensuite
la couche sacrificielle (2.1) est éliminée de manière localement définie avec de l'acide fluorhydrique grâce à un procédé d'attaque chimique, de sorte que la mobilité du au moins un élément microélectromécanique (5) est obtenue.

7. Procédé selon la revendication précédente, **caractérisé en ce que** la tranchée (6) est principalement, de manière préférée complètement, remplie avec du silicium, du germanium ou de l'oxyde d'aluminium.

8. Procédé selon la revendication 6, **caractérisé en ce que** la couche (4) est recouverte dans la tranchée (6) par au moins une autre couche, qui est de manière préférée constituée d'un métal, de manière particulièrement préférée de titane, de titane-aluminium ou d'aluminium, de cuivre ou de nitrure de titane.

9. Procédé selon l'une quelconque des deux revendications précédentes, **caractérisé en ce qu'**une couche barrière fermée (7) constituée d'oxyde d'aluminium est formée dans la couche sacrificielle (2), et des éléments de contact électrique (3) supplémentaires et/ou des électrodes (13) nécessaires à l'actionnement de l'élément microélectromécanique (5) sont formé(e)s sur la surface de la couche barrière (7) regardant en direction du au moins un élément microélectromécanique (5), lesquels éléments de contact électrique et/ou électrodes sont électriquement connecté(e)s à des éléments de contact électrique (3) agencés sous la couche barrière (7), et **en ce que** du matériau de la couche sacrificielle (2.1) situé au-dessus de la couche barrière (7) est ensuite éliminé par attaque chimique, de sorte que la mobilité de l'élément microélectromécanique (5) est obtenue.

10. Procédé selon l'une quelconque des trois revendications précédentes, **caractérisé en ce que** de l'acide fluorhydrique est utilisé sous forme de liquide ou de gaz pour l'attaque chimique afin d'éliminer de manière localement définie le matériau dont est constituée la couche sacrificielle (2.1).

11. Procédé selon l'une quelconque des quatre revendications précédentes, **caractérisé en ce que** le silicium ou l'oxyde d'aluminium est déposé dans la tranchée (6) au moyen d'une technologie PE-CVD (dépôt chimique en phase vapeur assisté par plasma), d'une pulvérisation cathodique ou d'un ALD (dépôt de couches atomiques) et la couche (4) est ainsi formée.
